# EUROPÄISCHE PATENTSCHRIFT

(11) **EP 2 638 601 B1**
(45) Veröffentlichungstag und Bekanntmachung des Hinweises auf die Patenterteilung: **29.10.2014**
(21) Anmeldenummer: 12702823.1
(22) Anmeldetag: 03.02.2012
(51) Int. Cl.: H01R 4/64, G01R 35/00

(54) **PRÜFANSCHLUSS FÜR EINEN STROMWANDLER**
TEST CONNECTION FOR A CURRENT TRANSDUCER
CONNECTION DE TEST POUR UN TRANSFORMATEUR DE COURANT

(30) Priorität: 15.02.2011 DE 102011004118
(43) Veröffentlichungstag der Anmeldung: 18.09.2013
(73) Patentinhaber: Siemens Aktiengesellschaft, 80333 München (DE)
(72) Erfinder: ANDREE, Hendrik, 96114 Hirschaid (DE); OEZTUERK, Nurettin, 75172 Pforzheim (DE); PRUCKER, Udo, 90571 Schwaig (DE)
(86) Internationale Anmeldenummer: PCT/EP2012/051829
(87) Internationale Veröffentlichungsnummer: WO 2012/110326

(56) Entgegenhaltungen:
- EP-A1- 1 398 850
- JP-A- 8 033 134

## Beschreibung

Die Erfindung betrifft einen Prüfanschluss zur Überprüfung eines Stromwandlers, insbesondere eines Stromwandlers einer gasisolierten Schaltanlage mit Messkernen außerhalb des Gasraumes, nachfolgend "außenliegender Stromwandler" genannt.

Aus dem Stand der Technik sind gasisolierte Schaltanlagen bekannt, bei denen die Bauteile eines Schaltfeldes mit einem Primärleiter innerhalb von gasdicht gekapselten Druckbehältern angeordnet sind. Zur elektrischen Isolation sind die Bauteile und der Primärleiter von einem Isoliergas, insbesondere SF₆, umgeben.

Typischerweise sind bei solchen gasisolierten Schaltanlagen Stromwandler vorgesehen, die zur Erfassung eines durch den Primärleiter fließenden elektrischen Stroms dienen. Solche Stromwandler sind üblicherweise als Ringkern-Stromwandler ausgeführt, die einen ringförmigen Messkern aus magnetisch hochpermeablem Material aufweisen und außerhalb des den Primärleiter führenden Druckbehälters angeordnet sind. Um den Umfang des Messkerns ist zumindest teilweise eine Wicklung eines elektrischen Leiters geführt, der Teil einer Messschaltung ist, so dass die den Primärleiter durchfließende Stromstärke induktiv messbar ist. Der gleiche Aufbau trifft auch auf Strommessvorrichtungen mit anderer Technologie zu, die insbesondere optische Stromsensoren, Rogowski-Spulen oder Hall-Sensoren aufweisen, welche zusätzlich zu den einzelnen Messkernen oder an Stelle der induktiven Messkerne des Stromwandlers eingesetzt werden.

Diese Messkerne und Sensoren des Stromwandlers müssen auf Funktionstüchtigkeit geprüft werden. Entsprechend der Sicherheitsregeln für Hochspannungsanlagen werden an die Lage, die Ausführung und dem Schaltzustand von Erdungs- und Trennschaltern beim Funktionstest der Stromwandler bestimmte Anforderungen gestellt.

Aus der JP 8033134 ist ein Stromwandler für eine gasisolierte Schaltanlage und ein Verfahren zur Überprüfung der Funktionstüchtigkeit des Stromwandlers bekannt, das ohne Erdungsschalter auskommt. Dazu sind Anschlüsse an dem die ringförmigen Messkerne des Stromwandlers tragenden, metallischen Trägerrohr vorgesehen und mit diesem einstückig verbunden, wobei die Anschlüsse von den Messkernen aus gesehen beidseitig am Trägerrohr angeordnet sind. Die ringförmigen Messkerne müssen so groß im Durchmesser gebaut werden, dass diese bei der Montage über die Anschlüsse geschoben werden können. Bei der Funktionsprüfung des Stromwandlers wird ein Strom durch das Trägerrohr geleitet, das somit die Funktion des Primärleiters übernimmt.

EP 1 398 850 A1 offenbart eine Erdleitungsbride mit einem Tragelement, das elektrisch leitend ausgebildet und auf einem Rohr zu befestigen ist, und mit einem Klemmelement, mit dem wenigstens ein Erddraht auf dem Tragelement mittels wenigstens einer Klemmvorrichtung festklemmbar ist.

Ausgehend von diesem Stand der Technik ist es Aufgabe der vorliegenden Erfindung, einen verbesserten Prüfanschluss zur Überprüfung eines Stromwandlers, insbesondere einer gasisolierten Schaltanlage anzugeben, der eine einfache, kosteneffiziente und sichere Überprüfung des Stromwandlers ermöglicht.

Die Aufgabe wird erfindungsgemäß gelöst durch einen Prüfanschluss für einen Stromwandler mit den charakterisierenden Merkmalen des Patentanspruchs 1.

Vorteilhafte Ausführungsformen der Erfindung sind Gegenstand der Unteransprüche.

Ein Stromwandler umfasst ein röhrenförmiges Trägerelement, innerhalb dessen ein Primärleiter angeordnet ist, und ein am röhrenförmigen Trägerelement umfänglich angeordneter ringförmiger Messkern, der zumindest teilweise mit einer Wicklung bewickelt ist. Ein Prüfanschluss für den Stromwandler umfasst mit dem Trägerelement elektrisch leitfähig verbundene Kontaktelemente. Erfindungsgemäß ist ein erstes Kontaktelement mittels Kraftschluss mit dem Trägerelement verbunden.

Das erste Kontaktelement kann auf besonders schnelle und einfache Weise am röhrenförmigen Trägerelement befestigt werden. Insbesondere ist eine Befestigung des ersten Kontaktelements nach der Montage der Messkerne am Trägerelement ermöglicht. Aufwändige Verfahrenschritte, wie insbesondere Schweiß- oder Lötverfahren zur Herstellung einer elektrisch leitfähigen Verbindung zwischen Trägerelement und Kontaktelement, sind vermieden.

Des Weiteren ist eine Vergrößerung des Innendurchmessers der ringförmigen Messkerne des Stromwandlers unnötig. Das für die Kernbestückung zur Verfügung stehende Bauvolumen kann somit trotz eingebautem Prüfanschluss nahezu vollständig ausgenutzt werden.

Bevorzugterweise ist das erste Kontaktelement bogenförmig ausgebildet, wobei eine Krümmung des bogenförmigen ersten Kontaktelements einer Krümmung des rohrförmigen Trägerelements entspricht. Bei der kraftschlüssigen Verbindung zwischen dem Trägerelement und dem ersten Kontaktelement liegt letzteres flächig auf und erstreckt sich umfänglich über einen Abschnitt des rohrförmigen Trägerelements, womit eine gute elektrisch leitfähige Kontaktierung zur Einleitung eines Prüfstroms in das Trägerelement sichergestellt ist. Das erste Kontaktelement stellt den Teil des Prüfanschlusses dar, der fest am Trägerelement eingebaut ist. Die für den Einbau des Messkerns nutzbare Kernträgerhöhe reduziert sich durch den Einbau des Prüfanschlusses somit nur geringfügig.

Das erste und/oder ein zweites Kontaktelement ist bzw. sind vorzugsweise aus einem Metall, insbesondere aus einem Aluminiummaterial, gefertigt.

Vorteilhafterweise ist das rohrförmige Trägerelement mit einem Innendruck beaufschlagbar und bildet einen Abschnitt eines das Schaltfeld und den Primärleiter umgebenden gasdichten Druckbehälters. Das rohrförmige Trägerelement ist mit einem Isoliergas, insbesondere SF₆, befüllt. Durch die kraftschlüssige Befestigung des ersten Kontaktelements mittels des Spannbands entfallen insbesondere aufwändige Schweißverfahren am Trägerelement, die eine nachträgliche und zusätzliche Materialprüfung erforderlich machen. Bei der kraftschlüssigen Verbindung entfällt die Notwendigkeit, die mechanische Prüfung des Trägerelements nach der Montage des Prüfanschlusses zu wiederholen. Insbesondere wird die Gasdruckfestigkeit von dem druckbeaufschlagten Trägerelement vom Einbau des Prüfanschlusses nicht beeinflusst. Eine gesonderte Druckbehälterprüfung kann somit entfallen.

Einer bevorzugten Ausführungsform der Erfindung zufolge ist das erste Kontaktelement mittels eines Spannbands, welches das röhrenförmige Trägerelement umfasst, kraftschlüssig am Trägerelement befestigt. Die Verwendung des Spannbands zur kraftschlüssigen Befestigung des ersten Kontaktelements ermöglicht die nachträgliche Montage des Prüfanschlusses an der bereits montierten Schaltanlage mit besonders einfachen und kostengünstigen Mitteln.

Das Spannband liegt an der Außenseite des Trägerelements eng an und besteht vorzugsweise aus elektrisch leitfähigem Material und insbesondere einem Metall. Dadurch ist die Kontaktfläche zur Übertragung des Prüfstromes auf besonders vorteilhafte Weise vergrößert und auftretende Kontaktwiderstände minimiert. Dies steigert insbesondere die Leistungsfähigkeit des Prüfanschlusses.

Bevorzugterweise weist das erste Kontaktelement Mittel zur elektrisch leitfähigen Verbindung mit zumindest einem bolzenförmigen Übertragungselement auf. Das bolzenförmige Übertragungselement dient zur Einspeisung des Prüfstroms. Das oder die bolzenförmigen Übertragungselemente sind lösbar mit dem ersten Kontaktelement verbindbar, bei Einspeisung schließt sich der Stromkreis über das rohrförmige Trägerelement und das zweite Kontaktelement stellt den Kontakt für die Rückleitung des Prüfstroms dar. Die lösbare Verbindung zwischen dem ersten Kontaktelement und dem Übertragungselement ermöglicht das Entfernen nicht benötigter Bestandteile des Prüfanschlusses nach Beendigung der Funktionsprüfung des Stromwandlers. Der Anlagenbetrieb ist somit nicht oder nur minimal beeinträchtigt.

Einer weiteren bevorzugten Ausführungsform der Erfindung zufolge umfasst das Mittel zur elektrisch leitfähigen Verbindung zwischen dem Übertragungselement und dem ersten Kontaktelement zumindest ein Schraubgewinde oder einen Steckanschluss. Der Prüfanschluss ist derart konstruiert, dass die Ausführung der restlichen Bauteile des außenliegenden Stromwandlers unverändert bleiben kann. Weiterhin ist der Einsatz weitgehend standardisierter Bauteile zur Einspeisung des Prüfstroms ermöglicht, die auf einfache Art und Weise mit dem ersten Kontaktelement elektrisch leitfähig verbindbar sind. Das Übertragungselement ist zur Funktionsprüfung des Stromwandlers einfach und schnell montierbar und kann nach Beendigung der Prüfung wieder demontiert werden.

Einem weiteren bevorzugten Ausführungsbeispiel zufolge ist das erste Kontaktelement mit einer Vielzahl von Übertragungselementen verbindbar, wobei die Übertragungselemente über das Trägerelement und über eine Anschlussplatte elektrisch leitfähig verbunden sind. Die Anschlussplatte bildet weiterhin eine Anschlusskontaktfläche zur Kontaktierung mit einer externen Strom- bzw. Spannungsquelle und stellt eine gleichmäßige Verteilung des Prüfstroms auf die einzelnen Übertragungselemente sicher.

Bevorzugterweise ist eine Vielzahl von ersten Kontaktelementen vorgesehen, die mit dem Trägerelement kraftschlüssig verbunden sind. Die einzelnen ersten Kontaktelemente sind miteinander elektrisch parallel und/oder in Reihe verschaltbar, so dass, den Anforderungen an den Stromwandler entsprechend, Prüfströme entsprechender Größe in das Trägerelement einleitbar sind. Somit ist die Stromträgfähigkeit des Messaufbaus an die spezifischen Anforderungen anpassbar.

Einer weiteren bevorzugten Ausführungsform der Erfindung zufolge ist das zweite Kontaktelement bogenförmig ausgebildet und am Trägerelement kraft- und formschlüssig, insbesondere mittels einer Schraubverbindung, befestigt. Das zweite Kontaktelement dient zur Rückführung des in das Trägerelement eingeleiteten Prüfstroms. Für die Durchführung der Funktionsprüfung des Stromwandlers ist keine Inbetriebnahme des primären Anlagenstromkreises nötig. Der Prüfstrom kann durch eine externe Stromquelle erzeugt und eingespeist werden. Anforderungen an die Lage und Ausführung von Erdungsschaltern entfallen damit und eine schnelle und einfache Funktionsprüfung der Messkerne des Stromwandlers vor der Anlageninbetriebnahme wird ermöglicht.

Im Folgenden wird die Erfindung anhand von Zeichnungen näher erläutert. Dabei zeigen:
- FIG 1: einen außenliegenden Stromwandler mit Prüfanschluss in einer perspektivischen Darstellung, und
- FIG 2: den außenliegenden Stromwandler mit Prüfanschluss in einer Schnittdarstellung.

Einander entsprechende Teile sind in allen Zeichnungen mit den gleichen Bezugszeichen versehen.

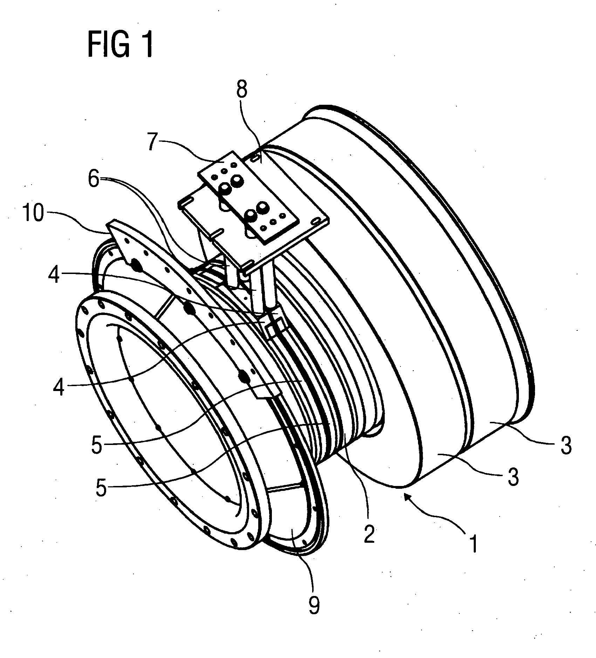

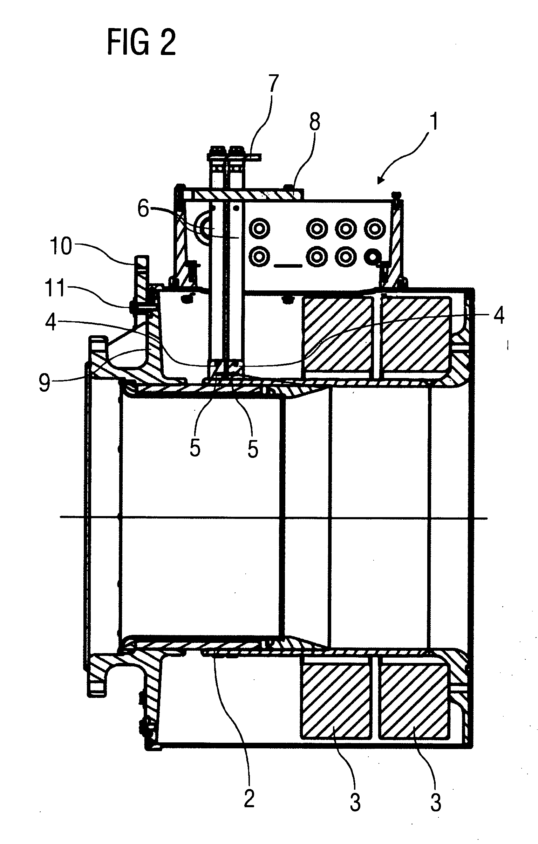

Figuren 1 und 2 zeigen einen außenliegenden Stromwandler 1 für eine gasisolierte Schaltanlage, in einer perspektivischen Darstellung und in einer Schnittdarstellung. Der Stromwandler 1 umfasst ein rohrförmiges Trägerelement 2, das gasdicht ausgebildet ist und mit einem Innendruck beaufschlagbar ist. Innerhalb des Trägerelements 2 ist in nicht näher dargestellter Weise ein hochstromleitender Primärleiter der Schaltanlage angeordnet, der von einem elektrisch inerten Isoliergas umgeben ist.

Zwei ringförmige Messkerne 3 aus einem magnetisch hochpermeablen Material wie beispielsweise einem Eisenwerkstoff umfassen das rohrförmige Trägerelement 2 umfänglich. Jeder der Messkerne 3 weist in nicht näher dargestellter Weise zumindest abschnittsweise eine Wicklung eines elektrischen Leiters auf. Die Wicklung ist Teil einer Messschaltung zur induktiven Messung eines den Primärleiter durchfließenden Stroms. Der durch den Primärleiter fließende Strom induziert in den Wicklungen einen zur primären Stromstärke im Wesentlichen proportionalen Sekundärstrom.

In den Figuren 1 und 2 sind zwei zueinander parallel angeordnete und bogenförmige erste Kontaktelemente 4 eines Prüfanschlusses dargestellt, welche mittels Kraftschluss an der äußeren Mantelfläche des rohrförmigen Trägerelements 2 befestigt sind. Alternativ kann auch nur ein erstes Kontaktelement 4 am Trägerelement 2 kraftschlüssig angeordnet sein.

Jedes der beiden ersten Kontaktelemente 4 ist mittels eines jeweiligen Spannbands 5, das das Trägerelement 2 umfasst, auf die äußere Mantelfläche des Trägerelements 2 kraftschlüssig aufgespannt. Das jeweilige erste Kontaktelement 4 liegt flächig auf der äußeren Mantelfläche des Trägerelements 2 auf, so dass eine gute elektrische Leitfähigkeit zwischen dem Trägerelement 2 und den ersten Kontaktelementen 4 sichergestellt ist.

Das jeweilige erste Kontaktelement 4 ist aus einem Aluminiumwerkstoff gefertigt. Das Spannband 5 besteht aus einem metallischen Werkstoff, so dass die elektrisch leitfähige Oberfläche des Prüfanschlusses vergrößert ist.

Jedes der ersten Kontaktelemente 4 weist Mittel zur Verbindung mit einem bolzen- bzw. stiftförmigen und elektrisch leitfähigen Übertragungselement 6 in Form eines Schraubgewindes oder einer Steckverbindung auf.

Zur Funktionsprüfung des außenliegenden Stromwandlers 1 ist mittels der Übertragungselemente 6 und den ersten Kontaktelementen 4 ein Prüfstrom von einer externen Stromquelle in das Trägerelement 2 einleitbar. Dazu sind die Übertragungselemente 6 des Prüfanschlusses in die jeweiligen ersten Kontaktelemente 4 einschraubbar oder einsteckbar. Die Stromtragfähigkeit des Prüfanschlusses ist über die Anzahl der verwendeten Übertragungselemente 6 auf die spezifischen Anforderungen der Funktionsprüfung anpassbar. Insbesondere kann ein eingeleiteter Prüfstrom von mehreren Kiloampere bei einer entsprechenden Anzahl von Übertragungselementen 6 realisiert werden.

Die einzelnen Übertragungselemente 6 sind mittels einer Anschlussplatte 7 und dem Trägerelement 2 miteinander elektrisch leitfähig verbunden. Die Anschlussplatte 7 ist besonders einfach an die externe Stromquelle mittels nicht weiter dargestellter Zuleitungskabel elektrisch leitend anschließbar. Des Weiteren stellt die Anschlussplatte 7 eine gleichmäßige Verteilung des eingeleiteten Prüfstroms auf die einzelnen Übertragungselemente 6 sicher.

Die Übertragungselemente 6 sind durch eine Isolierplatte 8 geführt, die als Halterung der Übertragungselemente 6 dient. Dies ermöglicht eine einfache und schnelle Kontaktierung der Übertragungselemente 6 mit den entsprechenden bogenförmigen ersten Kontaktelementen 4 zum Aufbau des Prüfanschlusses.

Nach Beendigung der Funktionsprüfung des Stromwandlers 1 ist der Prüfaufbau umfassend die Anschlussplatte 7, die Isolierplatte 8 und die Vielzahl von Übertragungselementen 6 aus der Verankerung mit den jeweiligen ersten Kontaktelementen 4 lösbar, so dass im Anlagenbetrieb nur die ersten Kontaktelemente 4 mit dem Trägerelement 2 verbunden bleiben und somit eine Beeinträchtigung des Anlagenbetriebs weitgehend vermieden ist. Zusätzlich dient bei der Einspeisung des Prüfstroms die Isolierplatte 8 als mechanische Abstützung für die Zuleitungskabel, die die Anschlussplatte 7 mit der externen Stromquelle elektrisch leitfähig verbindet.

In einem bevorzugten Ausführungsbeispiel ist eine Vielzahl von ersten Kontaktelementen 4 vorgesehen, die untereinander zur Einspeisung von Prüfströmen unterschiedlicher Größe miteinander parallel und/oder in Reihe verschaltbar sind. Die Stromtragfähigkeit des Prüfanschlusses ist an die Anforderungen der Funktionsprüfung modular anpassbar, indem eine der Stärke des Prüfstroms entsprechende Anzahl von Übertragungselementen 6 vorgesehen ist, die mit den entsprechenden ersten Kontaktelementen 4 insbesondere mittels Einschraubens bzw. Einsteckens elektrisch leitfähig verbindbar sind.

Die Stromtragfähigkeit des Trägerelements 2 entspricht im Wesentlichen der Stromtragfähigkeit des Primärleiters. Dies ermöglicht die Funktionsprüfung des Stromwandlers 1 vor der Inbetriebnahme der Schaltanlage. Insbesondere kann die Funktionsprüfung des Stromwandlers 1 für die im Anlagenbetrieb typisch auftretenden Stromstärken durchgeführt werden, ohne dass auf der Primärleitung bereits während der Prüfung eine Spannung anliegt.

Das Trägerelement 2 weist einen Flansch 9 auf, an dem ein zweites Kontaktelement 10 kraft- und formschlüssig befestigt ist. In dem in den Figuren 1 und 2 dargestellten Ausbildungsbeispiel ist das bogenförmige zweite Kontaktelement 10 mittels Schrauben 11 mit dem Flansch 9 verbunden. Diese Verbindung stellt eine gute elektrische Leitfähigkeit zwischen dem zweiten Kontaktelement 10 und dem Trägerelement 2 sicher. Des Weiteren ist die Verbindung zwischen dem zweiten Kontaktelement 10 und dem Flansch 9 lösbar, so dass auch das zweite Kontaktelement 10 nach Beendigung der Funktionsprüfung des Stromwandlers 1 entfernt werden kann. Das zweite Kontaktelement 10 ist aus einem Aluminiumwerkstoff gefertigt und elektrisch leitfähig kontaktierbar und dient bei der Funktionsprüfung zur Rückleitung des in das Trägerelement 2 eingeleiteten Prüfstroms.

Alternativ dazu kann das zweite Kontaktelement 10 auch fest, beispielsweise mittels einer Schweiß- oder Nietverbindung, mit dem Flansch 9 verbunden sein.

## Patentansprüche

1. Prüfanschluss für einen Stromwandler (1), der ein röhrenförmiges Trägerelement (2), innerhalb dessen ein Primärleiter angeordnet ist, und einen am röhrenförmigen Trägerelement (2) umfänglich angeordneten ringförmigen Messkern (3), der zumindest teilweise mit einer Wicklung bewickelt ist, umfasst, wobei das Trägerelement (2) mit Kontaktelementen (4, 10) elektrisch leitfähig verbunden ist und ein erstes Kontaktelement (4) mittels Kraftschluss mit dem Trägerelement (2) verbunden ist,
**dadurch gekennzeichnet, dass** eine Vielzahl von ersten Kontaktelementen (4) mit dem Trägerelement (2) kraftschlüssig verbunden ist, wobei die Kontaktelemente (4) miteinander elektrisch parallel und/oder in Reihe schaltbar sind.

2. Prüfanschluss nach Anspruch 1,
**dadurch gekennzeichnet, dass** das erste Kontaktelement (4) bogenförmig ausgebildet ist, wobei eine Krümmung des ersten Kontaktelements (4) einer Krümmung des rohrförmigen Trägerelements (2) entspricht.

3. Prüfanschluss nach Anspruch 1 oder 2,
**dadurch gekennzeichnet, dass** das erste und/oder ein zweites Kontaktelement (4, 10) aus einem Metall gefertigt ist.

4. Prüfanschluss nach einem der vorherigen Ansprüche,
**dadurch gekennzeichnet, dass** das erste Kontaktelement (4) mittels eines Spannbands (5), welches das röhrenförmige Trägerelement (2) umfasst, kraftschlüssig am Trägerelement (2) befestigt ist.

5. Prüfanschluss nach Anschluss 4,
**dadurch gekennzeichnet, dass** das Spannband (5) aus einem elektrisch leitfähigem Material, insbesondere einem Metall gefertigt ist.

6. Prüfanschluss nach einem der vorherigen Ansprüche,
**dadurch gekennzeichnet, dass** das erste Kontaktelement (4) Mittel zur elektrisch leitfähigen Verbindung mit zumindest einem bolzenförmigen Übertragungselement (6) aufweist.

7. Prüfanschluss nach Anspruch 6,
**dadurch gekennzeichnet, dass** das Mittel zur elektrisch leitfähigen Verbindung zumindest ein Schraubgewinde oder einen Steckanschluss umfasst.

8. Prüfanschluss nach Anspruch 6 oder 7,
**dadurch gekennzeichnet, dass** das erste Kontaktelement (4) mit einer Vielzahl von Übertragungselementen (6) verbindbar ist, wobei die Übertragungselemente (6) mittels einer Anschlussplatte (7) miteinander elektrisch leitfähig verbunden sind.

9. Prüfanschluss nach einem der vorherigen Ansprüche,
**dadurch gekennzeichnet, dass** das zweite Kontaktelement (10) bogenförmig ausgebildet ist und am Trägerelement (2) mittels einer Schraubverbindung oder Schweißverbindung oder Nietverbindung befestigt ist.

## Claims

1. Test connection for a current converter (1), which comprises a tubular support element (2) within which a primary conductor is situated, and an annular measuring core (3) that is situated around the circumference of the tubular support element (2) and least partially wound with a winding, wherein the support element (2) is electrically conductively connected to contact elements (4, 10), and a first contact element (4) is non-positively connected to the support element (2), **characterized in that** a plurality of first contact elements (4) is non-positively connected to the support element (2), wherein the contact elements (4) can be electrically interconnected in parallel and/or in series.

2. Test connection according to Claim 1, **characterized in that** the first contact element (4) is arc-shaped, wherein a curvature of the first contact element (4) corresponds to a curvature of the tubular support element (2).

3. Test connection according to claim 1 or 2, **characterized in that** the first and/or a second contact element (4, 10) is manufactured from a metal.

4. Test connection according to one of the previous claims, **characterized in that** the first contact element (4) is non-positively attached to the support element (2) via a tension band (5), which surrounds the tubular support element (2).

5. Test connection according to Claim 4, **characterized in that** the tension band (5) is manufactured from an electrically conductive material, in particular, a metal.

6. Test connection according to one of the previous claims, **characterized in that** the first contact element (4) has means for electrically conductive connection to at least one boltshaped transmission element (6).

7. Test connection according to Claim 6, **characterized in that** the means for electrically conductive connection comprises at least one screw thread or one plug connection.

8. Test connection according to Claim 6 or 7, **characterized in that** the first contact element (4) can be connected to a plurality of transmission elements (6), wherein the transmission elements (6) are electrically conductively connected to each other via a connecting plate (7).

9. Test connection according to one of the previous claims, **characterized in that** the second contact element (10) is arc-shaped and is attached to the support element (2) via a screw connection or a welded connection or a riveted connection.

## Revendications

1. Connexion de test pour un transformateur ( 1 ) de courant, qui comprend un élément ( 2 ) de support en forme de tube, à l'intérieur duquel est disposé un conducteur primaire, et un noyau ( 3 ) annulaire de mesure, disposé autour de l'élément ( 2 ) de support en forme de tube et bobiné au moins partiellement par un enroulement, l'élément ( 2 ) de support étant relié d'une manière conductrice de l'électricité à des éléments ( 4, 10 ) de contact et un premier élément ( 4 ) de contact est relié à coopération de force à l'élément ( 2 ) de support, **caractérisée en ce qu'**une pluralité de premiers éléments de contact sont reliés à coopération de force à l'élément ( 2 ) de support, les éléments ( 4 ) de contact étant montés électriquement entre eux en parallèle et/ou en série.

2. Connexion de test suivant la revendication 1,
**caractérisée en ce que** le premier élément ( 4 ) de contact est en forme d'arceau, une courbure du premier élément ( 4 ) de contact correspondant à une courbure de l'élément ( 2 ) tubulaire de support.

3. Connexion de test suivant la revendication 1 ou 2,
**caractérisée en ce que** le premier et/ou un deuxième élément( ( s ) ( 4, 10 ) de contact sont en un métal.

4. Connexion de test suivant l'une des revendications précédentes,
**caractérisée en ce que** le premier élément ( 4 ) de contact est fixé à l'élément ( 2 ) de support à coopération de force, au moyen d'un collier ( 5 ) de serrage, qui enserre l'élément ( 2 ) de support en forme de tube.

5. Connexion de test suivant la revendication 4,
**caractérisée en ce que** le collier ( 5 ) de serrage est en un matériau conducteur de l'électricité, notamment en un métal.

6. Connexion de test suivant l'une des revendications précédentes,
**caractérisée en ce que** le premier élément ( 4 ) de contact a des moyens de liaison d'une manière conductrice de l'électricité à au moins un élément ( 6 ) de transmission en forme d'axe.

7. Connexion de test suivant la revendication 6,
**caractérisée en ce que** le moyen de liaison d'une manière conductrice de l'électricité comprend au moins un filetage de vis ou une connexion enfichable.

8. Connexion de test suivant la revendication 6 ou 7,
**caractérisée en ce que** le premier élément ( 4 ) de contact peut être relié à une pluralité d'éléments ( 6 ) de transmission, les éléments ( 6 ) de transmission étant reliés d'une manière conductrice de l'électricité entre eux au moyen d'une plaque ( 7 ) de connexion.

9. Connexion de test suivant l'une des revendications précédentes,
**caractérisée en ce que** le deuxième élément ( 10 ) de contact est en forme d'arceau et est fixé à l'élément ( 2 ) de support au moyen d'un vissage ou d'un soudage ou d'un rivetage.
